# EUROPEAN PATENT APPLICATION

(11) **EP 1 860 165 A1**
(43) Date of publication of application: **28.11.2007**
(21) Application number: 06290867.8
(22) Date of filing: 24.05.2006
(51) Int. Cl.: C09D 175/04, F28F 13/18, H01L 23/373

(54) **Organic coated metallic substrate with enhanced heat transfer properties and method of production thereof**

(71) Applicant: ARCELOR France, 93200 Saint Denis (FR)
(72) Inventor: Ghosh, Swapan Kumar, 9260 Wichelen (Serskamp) (BE)
(74) Representative: Plaisant, Sophie Marie

(57) **Abstract**

The invention deals with an organic coated metallic substrate with enhanced heat transfer properties, comprising a metallic substrate, eventually coated on at least one face by a metallic layer improving the corrosion resistance of said substrate and coated one at least one face by a polyurethane-containing layer comprising graphite in an amount of more than 5% by weight of said layer, as well as with a method of production of such a coated substrate.

## Description

The present invention deals with an organic coated metallic substrate with enhanced heat transfer properties and its method of production, said coated substrate being especially of use for the manufacturing of electrically supplied devices, such as electrical heating systems, electrical housings, casings of electronic equipments, street lamps, etc...

In electronics especially, thermal management is crucial for circuit-board assemblies, as each circuit must be kept within its specified operating temperature range to remain fully operational. Moreover, if the generated heat in such a circuit or in an electronic component gets to high, it may give rise to structural stresses in the circuit board and the solder joints.

In electrical heating systems, such as convection radiators, the heat transfer properties of the materials building those systems must be as high as possible to improve the energetic efficiency of the system.

Metallic substrates in the shape of plates have been used for such applications and are usually made of aluminium which exhibits relatively good heat transfer properties, but of an insufficient level yet.

Some steel plates were also used, but have been previously coated with multilayer coating systems including adhesion layers between the substrate and the coating systems, the coatings being present for improving the heat absorption properties. Those products are often referred as "heat sinks".

Apart from being expensive to produce due to the many coating operations required, the coating layers often include environmentally toxic products which must be avoided in the future. Moreover, their heat absorption properties are not sufficient regarding the increase of cooling power required for the new generation of miniaturized microprocessors.

In addition, those metallic substrates are usually required to have a good corrosion resistance, in order to guaranty longer service duration.

The purpose of the present invention is therefore to put at disposal a new metallic substrate with improved heat transfer properties, such substrate presenting a good corrosion resistance and being easy to produce in an environmentally friendly way, without using toxic elements.

According to this, a first object of the present invention is an organic coated metallic substrate with enhanced heat transfer properties, comprising a metallic substrate, optionally coated on at least one face by a metallic layer improving the corrosion resistance of said substrate and coated on at least one face by a polyurethane-containing layer comprising graphite in an amount of more than 5% by weight of said layer.

The product according to the invention can also comprise several other characteristics, alone or in combination, such as:
- the organic coated metallic substrate comprises more than 10% graphite by weight of said layer, and preferably more than 15% by weight, and most preferably more than 30% by weight,
- the organic coated metallic substrate present a thickness of said polyurethane-containing layer lies between 1 and 15 µm, preferably between 2 and 10 µm, and more preferably between 2 and 4 µm,
- the organic coated metallic substrate is such that said graphite is incorporated in a divided form inside said polyurethane-containing layer,
- the organic coated metallic substrate is such that said graphite is incorporated in the form of particles having a mean diameter lying between 0.1 and 5 µm,
- the graphite is incorporated in the form of a colloidal dispersion or of a powder,
- the organic coated metallic substrate is based on a steel plate as substrate,
- the organic coated metallic substrate is such that said substrate is a steel plate coated on at least one face with a zinc or zinc-alloy layer, said zinc or zinc-alloy coated face being itself coated with said polyurethane-containing layer,
- the organic coated metallic substrate present a zinc layer obtained through hot-dip coating,
- the organic coated metallic substrate presents a zinc layer obtained through electro-deposition,
- the organic coated metallic substrate is such that said substrate is a steel plate coated on both faces with a zinc or zinc-alloy layer, one of those faces being itself coated with said polyurethane-containing layer, and the other face being coated with a layer of paint or of varnish,
- the organic coated metallic substrate is such that the polyurethane-containing layer was obtained through use of a formulation consisting of a waterborne dispersion,
- the organic coated metallic substrate is such that the polyurethane-containing layer was obtained through use of a formulation comprising a UV curable resin and no organic solvent,
- the organic coated metallic substrate presents a total emissivity in the range of 0.80 to 0.94, preferably above 0.90, and more preferably above 0.93.

A second object of the present invention is a method of manufacturing of an organic coated metallic substrate according to the invention, wherein said method includes the following steps:
■ providing a metallic substrate and eventually coating at least one face thereof with a metallic layer improving the corrosion resistance of said substrate,
■ coating at least one face of said metallic substrate with an organic formulation comprising graphite in an amount of more than 5% by weight and polyurethane monomers, oligomers polymers and/or co-polymers,
■ drying and/or curing said organic layer.

The method according to the invention can also comprise several other embodiments, taken alone or in combination, such as:
- the organic formulation comprising graphite in an amount of more than 10% by weight and polyurethane monomers, oligomers polymers and/or co-polymers,
- the metallic substrate is a steel plate, which is first coated with a zinc or zinc-alloy layer by hot-dip coating,
- the metallic substrate is a steel plate, which is first coated with a zinc layer by electro-deposition,
- at least one face of said metallic substrate is coated with an organic formulation consisting of a waterborne dispersion of monomers, oligomers, polymers and/or co-polymers including graphite particles, which is dried after deposition,
- at least one face of said metallic substrate is coated with an organic formulation consisting of a UV curable resin comprising polyurethane oligomers and/or polymers, acrylate monomers and/or oligomers, photo-initiators and including graphite particles, but including no organic solvent, which is cured after deposition.

Other characteristics and advantages of the invention will appear through the detailed description which will follow, only given as a mere example.

The present invention concerns metallic substrates and their use as "heat sinks" especially. Those metallic substrates can take any appropriate shape related to their intended use. However, the most commonly used shape is a metallic sheet or plate. The metals involved can be of any nature, and can be notably selected among, carbon steels (preferably aluminum-killed steels), stainless steels, aluminum or aluminum alloys, copper or copper alloys. The definitive choice will also rely on the required characteristics for the final use of the component to be produced, such as stiffness, hardness, flexibility, gloss, corrosion behavior in various environments, by example. The choice of substrate made of metal allows starting from a good heat transfer property, which can be further improved by an adequate coating system.

As previously explained, the component must sometimes have to resist to corrosion which imposes a complementary corrosion protective layer made of metal. This layer is preferably made of zinc, but can also be made of zinc alloys, such as zinc-iron, zinc-aluminum, zinc-aluminum-magnesium alloys, or of aluminum or aluminum alloys, by example. Depending on the nature of the metal, the process of deposition can notably be a hot dip coating process or an electro-deposition process, but other processes like PVD deposition could also be employed. This metallic coating can be deposited on one or one both faces of the substrate.

After the eventual metallic coating, the metallic substrate is next coated with a polyurethane-containing layer comprising graphite in an amount of more than 5% by weight of said layer. This layer can be obtained by different processes with a preference for the processes involving no other solvent than water. This coating can take place on one or both faces of the substrate and is usually done by roll-coating or by spraying.

A first embodiment can be to perform the coating with a formulation consisting of a waterborne dispersion of polyurethane monomers, oligomers, polymers and/or co-polymers, including graphite, which is dried after deposition in order to evaporate water.

In order to get a very flexible coating, it is preferred to use a sequenced co-polymer comprising alternate blocks of polyurethane and aliphatic polyester. Apart from those elements, the formulation can also contain some usual additives in order to improve certain characteristics of the coating, such as corrosion inhibitors.

Another embodiment can be to perform the coating with a formulation consisting of a UV curable resin comprising polyurethane oligomers and/or polymers, acrylate monomers and/or oligomers, photo-initiators, including graphite but no organic solvent. After deposition of the formulation, it is next cured by exposure to UV lamps. Apart from those elements, the formulation can also contain some usual additives.

In both cases, it has been observed that neither adhesion layer, nor any pre-treatment layer such as conversion coatings (chromium-containing or chromium-free) is required between the surface of the metallic substrate and the polyurethane-containing layer, which makes the manufacturing method simpler and less expensive.

The graphite added to both formulations is preferably included under a divided form such as particles with a mean diameter of 0.1 to 0.5 µm. It has also been observed that the particle size influences the final properties of the coating, as coatings containing smaller particles show higher emissivity. It can be added as a powder, but also as a colloidal dispersion, which latter choice is preferred because smaller particles size can be obtained. The colloidal dispersion can be very easily added to the waterborne dispersions, but is not well adapted to the UV curable resins, where powders are preferred. Graphite also has the advantage of being an environmentally-friendly material.

Finally, when the coating of the metallic substrate with the polyurethane-containing layer has only taken place on one side of the substrate, the other can be coated with paint or with a finishing varnish, usually by a roll-coating or a spraying process. In case of deposition of powder paint, this can be done by projection on the substrate followed by a baking operation.

Some experiments were achieved on several embodiments of the invention, in order to show the technical benefits of the invention regarding properties such as emissivity and heat removal potential.

### Example 1-Waterborne formulation - Emissivity and coating formulation

Emissivity is defined as the ability of a material to emit heat via infrared radiations to the surrounding atmosphere. The values range from 0 to 1. The higher the value, the faster the heat transfer takes place.

A first row of experiments was performed on aluminium-killed steel plates coated on both faces with a zinc layer obtained by hot dip coating. One face of the steel plate was then coated, according to the invention, with a waterborne dispersion obtained by mixing a colloidal graphite dispersion in water (containing 18% in weight of graphite - Aquadag® from Acheson colloids, Netherlands) with an aqueous dispersion containing a sequenced co-polymer of polyurethane and aliphatic polyester (Betafin® LS9010, solid content 35% by weight), in various ratios.

The graphite particles included in the dispersion had a mean diameter of 0.9 µm.

Two different experiments were carried out with a thickness of 2 µm in the first case and with a thickness of 5 µm in the second case, both thicknesses being measured after drying. The weight percentage of graphite was varied and the corresponding emissivity values were measured using an internal procedure and a IR Raytek ST60 pyrometer.

The internal procedure consists in wielding a plate of material to be tested, to a thermocouple. The thermocouple is connected to a computer receiving the temperature data. The test plate is then put in an oven and heated at six temperatures: 20°C, 40°C, 60°C, 80°C, 100°C and 120°C.

An IR Raytek ST60 pyrometer is used to measure the temperature at the surface of the steel plate. As the measured temperature is different from the one collected by the computer, the emissivity pre-defined value of the pyrometer is modified so as to obtain a temperature identical with the one collected by the computer. The modified value of emissivity introduced in the pyrometer is the Emissivity of the test plate.

The results of those experiments are given in table 1.

**Table 1**

| | Graphite in the coating formulation (% by weight) | | |
|---|---|---|---|
| | 5% | 9% | 10% |
| Emissivity 2µm-thick | 0.90 | 0.92 | 0.94 |
| Emissivity 5µm-thick | 0.93 | 0.94 | 0.94 |

As can be seen from those figures, the thickness of the coating can remain inferior or equal to 6 µm for the dried coating, as long as enough graphite is present in the coating. A concentration of more than 5% graphite and better of more than 10% by weight is therefore preferred. Moreover, it is also preferred to use a formulation containing less than 15% by weight as graphite tends to increase drastically the viscosity of the waterborne or UV curable formulations.

### Example 2 - Waterborne formulation - Emissivity and polymer type

Some samples according to the invention were prepared as in example 1, with a coating thickness of 5 µm for the dried coating and a ratio of 30% by weight of graphite dispersion and 70% by weight of Betafin®. The graphite content in the dried coating was estimated to 18.06 % by weight.

Some comparative samples were prepared on aluminium-killed steel plates coated on both faces with a zinc layer obtained by hot dip coating. One face of the steel plate was then coated with a waterborne dispersion obtained by mixing colloidal graphite dispersion in water (containing 18% in weight of graphite - Aquadag from Acheson colloids, Netherlands) with a polyacrylate-based polymer (Polyacrylate 1537, solid content 46.3% by weight). The coating thickness and graphite contents were identical with the samples according to the invention.

Emissivity of those comparative samples and of the invention samples were measured at different temperatures using the same procedure as in example 1.

**Table 2**

| Samples | Emissivity | | | | | |
|---|---|---|---|---|---|---|
| | 20°C | 40°C | 60°C | 80°C | 100°C | 120°C |
| Invention | 0.93 | 0.93 | 0.93 | 0.93 | 0.93 | 0.93 |
| Comparative | 0.78 | 0.78 | 0.78 | 0.78 | 0.78 | 0.78 |

It can be seen from this table that the use of a polyurethane formulation gives surprisingly better results that the use of a poly-acrylate formulation.

### Example 3 - UV curable formulation - Emissivity

A second row of experiments was performed on aluminium-killed steel plates coated on both faces with a zinc layer. Two different experiments were carried out with a hot-dip coated steel sheet in the first case and with an electro-galvanized steel sheet in the second case. One face of the steel plate was then coated with a UV curable formulation containing polyacrylate monomers, polyacrylate oligomers, polyurethane polymer, polyester polymer, phosphate, photo-initiators and corrosion inhibitor (Beckrylux® UM3-C14, Becker Industries).

A powder of graphite particles of a mean diameter of 5µm (CR 296, Kromphyl graphite, Germany) was added to the formulation prior to its deposition on the plates. The coating was then cured using an UV lamp (4L Hg, 240W/cm). The weight percentage of graphite was varied and the corresponding emissivity values were measured using the same material and procedure as disclosed in example 1.

The results of those experiments are given in table 3.

**Table 3**

| | Graphite % in weight in the cured film | | | |
|---|---|---|---|---|
| | 0% | 5% | 10% | 15% |
| Emissivity hot-dip coated | 0.16 | 0.90 | 0.90 | 0.91 |
| Emissivity electro-galvanized | 0.70 | 0.94 | 0.94 | 0.94 |

It can be seen that electro-galvanized sample has a better performance than hot-dip coated sample.

### Example 4 - Waterborne formulation - Heat removal

A third row of experiments was performed in order to evaluate the heat transfer behaviour of the substrates according to the invention, compared to usual substrates.

The samples according to the invention are made of aluminium-killed steel plates coated on both faces with zinc layers obtained by hot-dip coating. They were next coated on one face with a waterborne formulation identical with the one used in example 1.

The same colloidal suspension of graphite as in example 1 was then added to the formulation prior to its deposition on the plates in an amount of 10% by weight. The thickness of the polyurethane-containing layer was of 2 µm for a first sample and of 6 µm for a second sample.

Those samples were compared to bare steel plates of the same steel composition as used in the samples according to the invention.

After preparation of those samples, their heat transfer behaviour was evaluated in two ways. The plates were put on a constantly heated box with a heater placed inside the box and connected to a constant power supply, the box having no lid. The temperature rise inside the box and the surface temperature of the steel plate were measured using thermocouples during two hours. The heater inside the box was connected to a stabilized power supply. The results are given in table 3 for the temperature of the box and in table 4 for the temperature of the surface of the steel.

**Table 4 - temperature of the box**

| | Time (min.) | | | | | | |
|---|---|---|---|---|---|---|---|
| | 0 | 20 | 40 | 60 | 80 | 100 | 120 |
| T (°C) Bare steel (comp) | 0 | 70 | 76 | 81 | 86 | 86 | 88 |
| T (°C) 2µm (invention) | 0 | 60 | 70 | 73 | 75 | 76 | 77 |
| T (°C) 6 µm (invention) | 0 | 58 | 66 | 70 | 73 | 75 | 76 |

Thanks to the coatings according to the invention, 11 to 12°C can be gained compared to usual steel plates.

**Table 5-temperature of the steel plate surface**

| | Time (min.) | | | | | | |
|---|---|---|---|---|---|---|---|
| | 0 | 20 | 40 | 60 | 80 | 100 | 120 |
| T (°C) Bare steel (comp) | 0 | 68 | 72 | 75 | 77 | 78 | 78 |
| T (°C) 2µm (invention) | 0 | 87 | 90 | 92 | 93 | 93 | 94 |
| T (°C) 6 µm (invention) | 0 | 83 | 88 | 90 | 92 | 92 | 93 |

It can be seen that a coating thickness under 6 µm is enough to get all benefits from the invention. Moreover, it can be seen that heat transfer takes place very quickly thanks to the invention.

## Claims

1. Organic coated metallic substrate with enhanced heat transfer properties, comprising a metallic substrate, optionally coated on at least one face by a metallic layer improving the corrosion resistance of said substrate and coated by a polyurethane-containing layer comprising graphite in an amount of more than 5% by weight of said layer.

2. Organic coated metallic substrate according to claim 1, wherein said polyurethane-containing layer comprises more than 15% graphite by weight of said layer.

3. Organic coated metallic substrate according to claim 1 or 2, wherein the thickness of said polyurethane-containing layer lies between 1 and 15 µm.

4. Organic coated metallic substrate according to claim 3, wherein the thickness of said polyurethane-containing layer lies between 2 and 10 µm, preferably between 2 and 4 µm.

5. Organic coated metallic substrate according to anyone of claims 1 to 4, wherein said graphite is incorporated in a divided form inside said polyurethane-containing layer.

6. Organic coated metallic substrate according to claim 5, wherein said graphite is incorporated in the form of particles having a mean diameter lying between 0.1 and 5 µm.

7. Organic coated metallic substrate according to claim 6, wherein said graphite is incorporated in the form of a colloidal dispersion or of a powder.

8. Organic coated metallic substrate according to anyone of claims 1 to 7, wherein said substrate is a steel plate.

9. Organic coated metallic substrate according to claim 8, wherein said substrate is a steel plate coated on at least one face with a zinc or zinc-alloy layer, said zinc or zinc-alloy coated face being itself coated with said polyurethane-containing layer.

10. Organic coated metallic substrate according to claim 9, wherein said zinc layer was obtained through hot-dip coating.

11. Organic coated metallic substrate according to claim 9, wherein said zinc layer was obtained through electro-deposition.

12. Organic coated metallic substrate according to anyone of claims 9 to 11, wherein said substrate is a steel plate coated on both faces with a zinc or zinc-alloy layer, one of those faces being itself coated with said polyurethane-containing layer, and the other face being coated with a layer of paint or of varnish.

13. Organic coated metallic substrate according to anyone of claims 1 to 12, wherein the polyurethane-containing layer was obtained through use of a formulation consisting of a waterborne dispersion.

14. Organic coated metallic substrate according to anyone of claims 1 to 12, wherein the polyurethane-containing layer was obtained through use of a formulation comprising a UV curable resin and no organic solvent.

15. Organic coated metallic substrate according to anyone of claims 1 to 14, presenting a total emissivity in the range of 0.80 to 0.94.

16. Organic coated metallic substrate according to claim 15, presenting a total emissivity in the range of 0.90 to 0.94.

17. Method of manufacturing of an organic coated metallic substrate according to anyone of claims 1 to 16, wherein said method includes the following steps:
■ providing a metallic substrate and optionally coating at least one face thereof with a metallic layer improving the corrosion resistance of said substrate,
■ coating at least one face of said metallic substrate with an organic formulation comprising graphite in an amount of more than 5% by weight and polyurethane monomers, oligomers polymers and/or co-polymers,
■ drying and/or curing said organic layer.

18. Method according to claim 17, wherein said metallic substrate is a steel plate, which is first coated with a zinc or zinc-alloy layer by hot-dip coating.

19. Method according to claim 17, wherein said metallic substrate is a steel plate, which is first coated with a zinc layer by electro-deposition.

20. Method according to anyone of claims 16 to 19, wherein at least one face of said metallic substrate is coated with an organic formulation consisting of a waterborne dispersion of polyurethane monomers, oligomers, polymers and/or co-polymers including graphite particles, which is dried after deposition.

21. Method according to anyone of claims 16 to 19, wherein at least one face of said metallic substrate is coated with an organic formulation consisting of a UV curable resin comprising polyurethane oligomers and/or polymers, acrylate monomers and/or oligomers, photo-initiators and including graphite particles, but including no organic solvent, which is cured after deposition.
